Europäisches Patentamt

European Patent Office

Office européen des brevets

(11) Numéro de publication: **0 247 267 B1**

(12) **FASCICULE DE BREVET EUROPEEN**

(45) Date de publication de fascicule du brevet:
02.10.91

(51) Int. Cl.⁵: **H01S 3/19**

(21) Numéro de dépôt: 86401106.9

(22) Date de dépôt: 26.05.86

(54) **Laser à semiconducteur muni de moyens de réinjection de l'émission spontanée dans la couche active.**

(43) Date de publication de la demande:
02.12.87 Bulletin 87/49

(45) Mention de la délivrance du brevet:
02.10.91 Bulletin 91/40

(84) Etats contractants désignés:
**DE GB**

(56) Documents cités:
EP-A- 0 038 981    EP-A- 0 042 585
EP-A- 0 099 782    FR-A- 2 575 870
GB-A- 2 040 552    GB-A- 2 079 524
GB-A- 2 098 385

(73) Titulaire: **Sermage, Bernard**
**13 rue des Marronniers**
**F-75016 Paris(FR)**

Titulaire: **Brillouet, François**
**34 bis, rue des Fontaines**
**F-92310 Sèvres(FR)**

(72) Inventeur: **Sermage, Bernard**
**13, rue des Marronniers**
**F-75016 Paris(FR)**
Inventeur: **Brillouet, François**
**34 bis, rue des Fontaines**
**F-92310 Sevres(FR)**

(74) Mandataire: **Mongrédien, André et al**
**c/o BREVATOME 25, rue de Ponthieu**
**F-75008 Paris(FR)**

Rank Xerox (UK) Business Services

# Description

La présente invention a pour objet un laser à semiconducteur muni de moyens de réinjection de l'émission spontanée dans la couche active. Elle trouve une application en télécommunications optiques.

Le domaine technique de l'invention est celui des lasers à semiconducteurs dits à double hétérostructure. Une telle structure est constituée d'un empilement de couches semiconductrices déposées par épitaxie sur un substrat monocristallin. On trouve en général, en partant du substrat, une couche tampon (facultative), une première couche de confinement, une couche active qui est responsable de l'émission de lumière, une seconde couche de confinement, une couche de contact et enfin une couche métallique. Le caractère de double hétérostructure vient de ce que la couche active est encadrée par deux couches dont la composition est différente de celle de la couche active.

Pour les lasers émettant entre 0,8 et 0,9 $\mu$m, les couches de confinement sont en alliage $Ga_{1-x}Al_xAs$ et la couche active et le substrat en GaAs ; pour les lasers émettant entre 1,3 et 1,65 $\mu$m, les couches de confinement sont en $Ga_{1-x}In_xAs_{1-y}P_y$ et la couche active et le substrat en InP.

Avec de telles structures, la densité de courant de seuil est de l'ordre de 1 kA/cm². Pour diminuer le courant de seuil proprement dit, on utilise différentes techniques permettant de délimiter un ruban actif de faible largeur. Le courant de seuil est alors de l'ordre de 1 mA environ.

Le but de la présente invention est de diminuer, d'une part, la densité de courant de seuil pour les structures de grandes surfaces et, d'autre part, le courant de seuil pour les structures à limitation latérale.

A cette fin, l'invention a recours à des moyens non plus électriques mais optiques. On connaît, par le document EP-A-38 981, un laser dans lequel la couche de contact supérieure est transparente de telle sorte que le rayonnement spontané émis par la couche active peut traverser cette couche de contact, se réfléchir sur la couche métallique supérieure, retraverser la couche de contact et revenir dans la couche active.

L'invention reprend cette disposition mais en ajoute une autre à la partie inférieure de la structure qui permet de renvoyer également la lumière spontanée émise vers le bas, dans la couche active.

Pour ce faire, il est nécessaire, d'une part, de décaper une partie du substrat pour ramener la couche métallique de contact inférieure sous l'empilement des couches épitaxiées et, d'autre part, d'ajouter une couche de contact inférieure entre la couche métallique et la première couche de confinement ; cette couche de contact doit posséder, comme la couche de contact supérieure, une composition telle qu'elle soit transparente à la longueur d'onde du rayonnement de la couche active. La partie de ce rayonnement qui est dirigée vers le bas de la structure peut alors être réfléchie sur la couche métallique et renvoyée dans la couche active.

Lorsque la couche active est en GaAs, les couches de contact sont en $Ga_{1-x}Al_xAs$ avec x voisin de 0,1, c'est-à-dire compris pratiquement entre 0,05 et 0,2.

La diminution du courant de seuil observée par l'artifice de l'invention peut être expliquée de la manière suivante.

La densité de courant de seuil d'un laser à semiconducteur est inversement proportionnelle à la durée de vie des porteurs. Celle-ci est donnée par la formule habituelle :

$$\frac{1}{\tau} = \frac{1}{\tau_{nr}} + \frac{1}{\tau_{ra}}$$

où $\tau_{nr}$ est la durée de vie non radiative et $\tau_{ra}$ la durée de vie radiative apparente.

La réabsorption du rayonnement spontané, dans la couche active, après réflexion sur la ou les couches métalliques supérieure et inférieure, provoque une augmentation de la durée de vie radiative apparente ; celle-ci entraîne une augmentation de $\tau$, qui provoque une réduction de la densité de courant de seuil.

Les mesures effectuées par les Demandeurs ont montré qu'avec une hétérostructure en GaAs/GaAlAs une réduction d'un facteur 5 pouvait être obtenue sur la densité de courant de seuil, laquelle tombe alors à 200 A/cm².

L'invention sera mieux comprise à la lumière de la description qui suit, de deux exemples de réalisation donnés à titre explicatif et nullement limitatif. Cette description se réfère à des dessins annexés sur lesquels :

- la figure 1 illustre le mécanisme par lequel la lumière émise vers le haut de la structure se réfléchit sur la couche métallique supérieure,
- la figure 2 illustre le mécanisme par lequel, en plus, la lumière émise vers le bas se réfléchit sur une couche métallique inférieure.

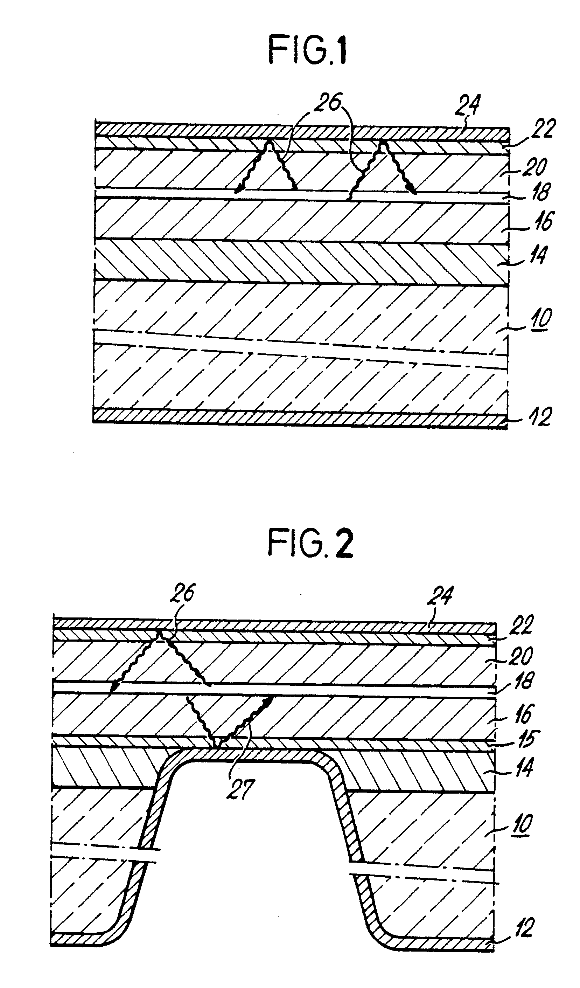

Le laser représenté sur la figure 1 comprend un substrat 10 recouvert, à la partie inférieure, d'une première couche métallique 12, et, à la partie supérieure, d'une couche tampon 14, d'une première couche de confinement 16 dopée n, d'une couche active 18 non dopée, d'une seconde couche de confinement 20 dopée p, d'une couche de contact 22 dopée p⁺ et d'une couche métallique 24. La couche de contact 22 ' est de composition telle qu'elle est transparente à la longueur d'onde du rayonnement émis par la couche active.

Dans le cas d'une hétérostructure GaAs/GaAlAs on peut avoir les compositions et les épaisseurs suivantes, sans que l'invention soit limitée à ce cas :

10 : GaAs, épaisseur 100 $\mu$m,

14 : GaAs dopé n ($10^{18}$cm$^{-3}$), épaisseur 1$\mu$m

16 : $Ga_{0,7}Al_{0,3}As$ dopé n ($10^{18}$cm$^{-3}$), épaisseur 1 $\mu$m,

18 : GaAs non dopé, épaisseur 0,15 $\mu$m,

20 : $Ga_{0,7}Al_{0,3}As$ dopé p ($10^{18}$cm$^{-3}$), épaisseur 1 $\mu$m,

22 : $Ga_{0,9}Al_{0,1}As$ dopé p$^+$ ($5.10^{18}$cm$^{-3}$), épaisseur 0,2 $\mu$m.

Les couches 20 et 22 en GaAlAs sont transparentes au rayonnement spontané émis par la couche 18 en GaAs et la partie 26 de ce rayonnement, qui est émise vers le haut, est réfléchie sur la couche métallique 24.

La figure 2 reprend la disposition de la figure 1 mais en ajoute une autre. Lors de l'épitaxie des couches sur le substrat, une couche supplémentaire de contact 15 a été prévue entre les couches 14 et 16. Ensuite, le substrat 10 est décapé sur une partie de sa longueur ainsi que la couche tampon 14. Cette gravure atteint la couche supplémentaire 15. La couche métallique 12 est alors déposée sur la partie inférieure du substrat ainsi gravé, de sorte que cette couche vient au contact de la couche 15. Comme pour la couche 22, la composition de la couche 15 est telle qu'elle soit transparente au rayonnement émis par la couche active. Dans le cas particulier évoqué plus haut, la couche 15 sera en $Ga_{0,9}Al_{0,1}As$. Elle sera dopée n$^+$ ($5.10^{18}$cm$^{-3}$) et aura une épaisseur de 0,2 $\mu$m environ. Ainsi, non seulement le rayonnement 26 dirigé vers le haut est renvoyé dans la couche active mais encore le rayonnement 27 dirigé vers le bas.

## Revendications

1. Laser à semiconducteur à double hétérostructure comprenant un substrat (10) recouvert sur la partie inférieure d'une première couche métallique (12) et, sur la partie supérieure, d'une couche tampon (14), d'une première couche de confinement (16) dopée n, d'une couche active (18) non dopée, d'une seconde couche de confinement (20) dopée p, d'une couche de contact (22) dopée p$^+$, et d'une couche métallique (24), la couche de contact (22) étant de composition telle que cette couche soit transparente à la longueur d'onde du rayonnement émis par la couche active (18), caractérisé par le fait qu'il comprend en outre, sur la couche tampon (14) et sous la première couche de confinement (16), une seconde couche de contact (15) de composition telle que cette couche soit transparente à la longueur d'onde du rayonnement émis par la couche active, et par le fait qu'une partie du substrat (10) et de la couche tampon (14) est décapée jusqu'à la seconde couche de contact (15), la première couche métallique (12), disposée sous le substrat, venant ainsi au contact de la seconde couche de contact (15).

2. Laser selon la revendication 1, caractérisé par le fait que la couche active (18) étant en GaAs, la première et la seconde couches de contact (22, 15) sont en $Ga_{1-x}Al_xAs$, avec un fort dopage p$^+$ pour la première et n$^+$ pour la seconde.

3. Laser selon la revendication 2, caractérisé par te fait que x est voisin de 0,1.

4. Laser selon l'une quelconque des revendications 1 à 3, caractérisé par le fait que le ruban actif est confiné latéralement.

## Claims

1. Double heterostructure semiconductor laser comprising a substrate (10) covered in its lower part by a first metal layer (12) and in its upper part by a buffer layer (14), a n-doped confinement layer (16), an undoped active layer (18), a second p-doped confinement layer (20), a p$^+$-doped contact layer (22) and a metal layer (24), the contact layer (22) having a composition such that it is transparent to the wavelength of the radiation emitted by the active layer (18), characterized in that it also comprises, on the buffer layer (14) and beneath the first confinement layer (16), a second contact layer (15) having a composition such that said layer is transparent to the wavelength of the radiation emitted by the active layer and in that part of the substrate (10) and the buffer layer (14) are etched down to the second contact layer (15), the first metal layer (12) located beneath the substrate thus coming into contact with the second contact layer (15).

2. Laser according to claim 1, characterized in that the active layer (18) is of GaAs and the first and second contact layers (22, 15) are of $Ga_{1-x}Al_xAs$, with high p$^+$ doping for the first and high n$^+$ doping for the second.

3. Laser according to claim 2, characterized in that x is close to 0.1.

4. Laser according to one of the claims 1 to 3, characterized in that the active ribbon is laterally confined.

**Patentansprüche**

1. Halbleiterlaser mit doppelter Heterostruktur, der ein Substrat (10) aufweist, welches auf seinem unteren Teil von einer ersten metallischen Schicht (12) und auf seinem oberen Teil von einer Pufferschicht (14), einer ersten n-dotierten Lichtleiterschicht (16), einer nicht dotierten aktiven Schicht (18), einer zweiten p-dotierten Lichtleiterschicht (20) einer $p^+$-dotierten Kontaktschicht (22) und einer metallischen Schicht (24) überdeckt ist, wobei die Kontaktschicht (22) eine solche Zusammensetzung hat, daß die Schicht für die Wellenlänge des von der aktiven Schicht (18) emittierten Lichts durchlässig ist, **dadurch gekennzeichnet, daß** er desweiteren auf der Pufferschicht (14) und unter der ersten Lichtleiterschicht (16) eine zweite Kontaktschicht (15) mit einer solchen Zusammensetzung aufweist, daß die Schicht für die Wellenlänge des von der aktiven Schicht emittierten Lichts durchlässig ist, und daß ein Teil des Substrats (10) und der Pufferschicht (14) bis zur zweiten Kontaktschicht (15) weggeätzt wird, wobei die unter dem Substrat angeordnete erste metallische Schicht (12) auf diese Weise mit der zweiten Kotaktschicht (15) in Kontakt kommt.

2. Laser nach Anspruch 1, **dadurch gekennzeichnet, daß** die aktive Schicht aus GaAs, die erste und zweite Kontaktschicht (22, 15) aus $Ga_{1-x}Al_xAs$ mit einer starken $p^+$-Dotierung für die erste und einer $n^+$-Dotierung für die zweite Schicht ist.

3. Laser nach Anspruch 2, **dadurch gekennzeichnet, daß** x nahe bei 0,1 liegt.

4. Laser nach einem der Ansprüche 1 bis 3, **dadurch gekennzeichnet, daß** das aktive Band seitlich eingegrenzt ist.

# FIG.1

# FIG.2